# EUROPÄISCHE PATENTANMELDUNG

(11) **EP 4 567 878 A1**
(43) Veröffentlichungstag der Anmeldung: **11.06.2025**
(21) Anmeldenummer: 23214828.8
(22) Anmeldetag: 07.12.2023
(51) Int. Cl.: H01L 23/367, H01L 23/427, H01L 23/00

(54) **ANORDNUNG FÜR EINE ELEKTRONISCHE RECHENEINRICHTUNG MIT ZUMINDEST EINEM LEISTUNGSMODUL UND EINEM KÜHLKÖRPER ZUM KÜHLEN DES LEISTUNGSMODULS**

(71) Anmelder: Siemens Aktiengesellschaft, 80333 München (DE)
(72) Erfinder: Bigl, Thomas, 91074 Herzogenaurach (DE); Heimann, Matthias, 14469 Potsdam (DE); Hensler, Alexander, 91466 Gerhardshofen (DE); Müller, Bernd, 16259 Falkenberg (DE); Pfeifer, Markus, 90455 Nürnberg (DE); Stencel, Lisa, 10553 Berlin (DE); Strogies, Jörg, 14163 Berlin (DE)
(74) Vertreter: Siemens Patent Attorneys

(57) **Zusammenfassung**

Die Erfindung betrifft eine Anordnung (10) für eine elektronische Recheneinrichtung mit zumindest einem Leistungsmodul (12) und einem Kühlkörper (14) zum Kühlen des Leistungsmoduls (12), dadurch gekennzeichnet, dass
zwischen dem Leistungsmodul (12) und dem Kühlkörper (14) eine Dampfkammereinrichtung (44) ausgebildet ist, wobei zumindest eine Seite (36) der Dampfkammereinrichtung (44) durch das Leistungsmodul (12) begrenzt ist und zumindest eine weitere Seite (50) der Dampfkammereinrichtung (44) durch den Kühlkörper (14) begrenzt ist.

## Beschreibung

Die nachfolgende Erfindung betrifft eine Anordnung für eine elektronische Recheneinrichtung mit zumindest einem Leistungsmodul an einen Kühlkörper zum Kühlen des Leistungsmoduls.

Leistungselektronische Module sind zunehmend durch extreme Leistungsdichten gekennzeichnet. Das bedingt die Herausforderung einer effektiven Abfuhr der entstehenden Verlustwärme. Eine wesentliche Schwachstelle in den Aufbauten besteht im Übergang zwischen dem Leistungsmodul und dem zur konvektiven Wärmeabgabe an luftnotwendigen Kühlkörpern. Diese Grenzflächen stellen allgemein einen limitierenden Faktor dar.

Im Stand der Technik wird diesem Problem beispielsweise durch die Berücksichtigung der Limitierung und entsprechende Auslegungen des Gesamtsystems entgegengetreten. Hierbei wird beispielsweise eine Verlustleistungsdichte begrenzt, oder Wärmeübergangsflächen entsprechend groß ausgebildet. Ferner ist die Anbindung der Module über großflächige Löt- beziehungsweise Sinterverbindungen sowie mit Wärmleitpasten bekannt. Ferner kann der Kühlkörper, insbesondere im sogenannten Interfacebereich, aus thermisch sehr gut leitfähigen Materialien ausgebildet sein. Ferner sind nicht-übergreifende Oberflächen Dampfkammereinrichtungen (Vapour Chambers) zur lateralen Wärmespreizung im Kühlkörper bekannt.

Aufgabe der vorliegenden Erfindung ist es eine Anordnung zu schaffen, welche eine verbesserte Entwärmung eines Leistungsmoduls einer elektronischen Recheneinrichtung realisiert.

Diese Aufgabe wird durch eine Anordnung gemäß dem unabhängigen Patentanspruch gelöst. Vorteilhafte Ausgestaltungsformen sind in den Unteransprüchen angegeben.

Ein Aspekt der Erfindung betrifft eine Anordnung für eine elektronische Recheneinrichtung mit zumindest einem Leistungsmodul und einem Kühlkörper zum Kühlen des Leistungsmoduls.

Es ist dabei vorgesehen, dass zwischen dem Leistungsmodul und dem Kühlkörper eine Dampfkammereinrichtung ausgebildet ist, wobei zumindest eine Seite der Dampfkammereinrichtung durch das Leistungsmodul begrenzt ist und zumindest eine weitere Seite der Dampfkammereinrichtung durch den Kühlkörper begrenzt ist.

Insbesondere kann somit eine grenzflächenübergreifende Dampfkammereinrichtung, welche auch als Vapour Chamber bezeichnet wird, für einen thermisch optimierten Wärmefluss durch die Eliminierung von kontaktbedingten thermischen Widerständen realisiert werden.

Im Stand der Technik, bei welchen das Leistungsmodul nicht stoffschlüssig an den Kühlkörper angebunden wird, können die zu fügenden Oberflächen nur begrenzt angenähert werden, weshalb ein Ausgleichsmedium zur Spaltschließung notwendig wird. Dies wird üblicherweise durch Wärmeleitpasten oder Gap Pads realisiert, welche mit einem erhöhten thermischen Übergangswiderstand sowie einer problematischen Langzeitstabilität der Anbindung durch Alterung und Herauspressen des Materials einhergehen. Die großflächige metallurgische Anbindung durch Löt-/Sinterverbindungen stellt hingegen hohe prozesstechnologische Anforderungen bezüglich Defektarmut (zum Beispiel Vermeidung von Fehlstellen wie Voids). Zudem ist die Stabilität dieser Führung gegenüber thermomechanischen Belastungen kritisch. Die Verwendung von Kühlkörper-Inlays aus Kupfer und Sondermaterialien sowie die Integration von nicht grenzüberflächengreifenden oberflächennahen Vapour Chambers verbessert zwar die Wärmespreizung, nicht aber die zuvor genannten Herausforderungen bezüglich seines Übergangs zwischen den Festkörpergrenzflächen.

Die erfindungsgemäße Lösung bietet eine deutliche Leistungssteigerung durch Adressierung der Gesamtheit der zuvor genannten Problemstellungen. Insbesondere kann erfindungsgemäß durch die grenzübergreifende Vapour Chamber ein optimierter Wärmeübergang zwischen dem Leistungsmodul und dem Kühlkörper realisiert werden.

Insbesondere kann somit eine Eliminierung der Festkörpergrenzflächen durch die Gestaltung einer gemeinsamen Vapour Chamber zwischen Leistungsmodul und Kühlkörper realisiert werden. Des Weiteren liegt eine Verbesserung der lateralen Wärmespreizung durch Ausdehnung der Kondensationsfläche innerhalb des Kühlkörpers vor. Ferner kann auch eine Funktionsintegration der unteren Metallisierungsschicht des Leistungsmoduls durch Gestaltung als obere Halbschale, insbesondere auf der Evaporationsseite, mit entsprechender Topografie realisiert werden. Ferner kann auch eine fertigungsgerechte Gestaltung der Anwendung einer auf den Kühlkörper gefügten Deckplatte realisiert werden.

Bei der Kühlung mithilfe einer Vapour Chamber handelt es sich insbesondere um eine Technik zur Wärmeverteilung, bei der die Verdampfung und Kondensation von Flüssigkeit zur Kühlung einer elektronischen Komponente genutzt wird. Insbesondere wird vorliegend nun die Dampfkammereinrichtung mit dem Kühlkörper kombiniert, um den Kühlprozess zu unterstützen.

Bei der Dampfkammereinrichtung handelt es somit insbesondere im Grunde um ein flaches Metallgehäuse, das mit einer Dochtstruktur ausgekleidet ist. Die Dampfkammereinrichtung ist dabei beispielsweise mit einer kleinen Menge Flüssigkeit, insbesondere dem Fluid, gefüllt, und vakuumversiegelt. Der niedrige Druck innerhalb der Dampfkammereinrichtung ermöglicht es der Flüssigkeit, bei Temperaturen zu verdampfen, die unter dem normalen Siedepunkt liegen. Wenn die Dampfkammereinrichtung durch eine elektronische Komponente, wie beispielsweise das Leistungsmodul, erhitzt wird, verdampft die Flüssigkeit. Dieser Dampf zirkuliert sodann durch Konvektion und bewegt sich frei durch die Dampfkammereinrichtung. Wenn dies auf eine kühle Oberfläche trifft, insbesondere dem Kühlkörper, kondensiert er und gibt die absorbierte Wärme ab. Die kondensierte Flüssigkeit bewegt sich daraufhin durch das Dochtmaterial und gelangt zurück auf die wärmere Seite. Und dieser Prozess setzt sich dabei fort, solange das elektronische Bauteil, insbesondere das Leistungsmodul, heiß ist.

Gemäß einer vorteilhaften Ausgestaltungsform sind an der Seite des Leistungsmoduls Kühlrippen ausgebildet. Insbesondere ragen die Kühlrippen zumindest bereichsweise in die Dampfkammereinrichtung hinein. Somit kann eine Flächenvergrößerung der Seite realisiert werden. Ferner kann über die Kühlrippenstruktur eine verbesserte Kapillarwirkung der Dampfkammereinrichtung realisiert werden. Die Kühlrippen können auch säulenförmig ausgebildet sein. Insbesondere kann somit ein erhöhter Wärmeeintrag von Seiten des Leistungsmoduls in die Dampfkammereinrichtung realisiert werden. Somit kann eine erhöhte Wärmeabfuhr durchgeführt werden.

Eine weitere vorteilhafte Ausgestaltungsform sieht vor, dass an der weiteren Seite des Kühlkörpers weitere Kühlrippen ausgebildet sind. Somit kann auch auf Seiten des Kühlkörpers, insbesondere in Richtung der Dampfkammereinrichtung betrachtet, die Oberfläche entsprechend erhöht werden. Somit kann ein verbesserter Wärmeübertrag von der Dampfkammereinrichtung hin zum Kühlkörper realisiert werden, wodurch eine größere Entwärmung der Anordnung realisiert werden kann.

Es hat sich weiterhin als vorteilhaft erwiesen, wenn die Seite zum Leistungsmodul eine geringere Fläche aufweist als die weitere Seite zum Kühlkörper. Insbesondere ist somit der Kühlkörper gegenüber dem Leistungsmodul größer dimensioniert.

Somit kann eine verbesserte Wärmeabgabe des Leistungsmoduls an den Kühlkörper realisiert werden.

In einer weiteren vorteilhaften Ausgestaltungsform ist vorgesehen, dass an zumindest einer Kontaktstelle des Leistungsmoduls mit dem Kühlkörper ein Dichtelement angeordnet ist. Insbesondere sind somit das Leistungsmodul und der Kühlkörper mehrstückig ausgebildet. Insbesondere ist dann zwischen den Leistungsmodulen im Kühlkörper ein Dichtelement angeordnet, sodass eine Abdichtung der Dampfkammereinrichtung realisiert werden kann. Somit kann ein Verlust des Fluids verhindert werden und gleichzeitig ein verbesserter Wärmeübertrag des Leistungsmoduls an den Kühlkörper realisiert werden.

Es hat sich weiterhin als vorteilhaft erwiesen, wenn das Leistungsmodul zumindest eine metallische Komponente aufweist und die metallische Komponente die Seite zur Dampfkammereinrichtung ausbildet. Insbesondere weist das Leistungsmodul eine Vielzahl von unterschiedlichen Schichten auf. Die metallische Komponente ist dabei insbesondere als untere Schicht des Leistungsmoduls anzusehen und ragt im Wesentlichen in die Dampfkammereinrichtung hinein beziehungsweise bildet eine Seite der Dampfkammereinrichtung. Somit kann direkt über die metallische Komponente ein verbesserter Wärmeübertrag in die Dampfkammereinrichtung realisiert werden.

Es hat sich weiterhin als vorteilhaft erwiesen, wenn die metallische Komponente aus Kupfer ausgebildet ist. Mit anderen Worten ist insbesondere die Seite, welche die Dampfkammereinrichtung mit dem Leistungsmodul teilt aus Kupfer ausgebildet. Kupfer hat dabei einen sehr hohen Wärmeleitkoeffizienten, sodass die Wärme, welche beispielsweise durch den Leistungschip des Leistungsmoduls gebildet wird, verbessert über die metallische Komponente, insbesondere die kupferne Komponente, in die Dampfkammereinrichtung übertragen werden kann.

Ferner hat es sich als vorteilhaft erwiesen, wenn die metallische Komponente gegenüber einem Leistungschip der Leistungskomponente elektrisch isoliert ist. Insbesondere kann somit verhindert werden, dass Ströme innerhalb des Leistungschips beziehungsweise Spannungen innerhalb des Leistungschips über die metallische Komponente in die Dampfkammereinrichtung übertragen werden können. Dadurch können insbesondere Kurzschlüsse verhindert werden.

In einer weiteren vorteilhaften Ausgestaltungsform ist die elektrische Isolation als eine Keramikschicht ausgebildet. Insbesondere Keramik hat dabei einen sehr guten Wärmeübertragungskoeffizienten und gleichzeitig eine Isolationswirkung. Somit kann auf zuverlässige Art und Weise und ohne Wärmeübertragungsverlust die Wärme aus dem Leistungsmodul, insbesondere von dem Leistungschip, entsprechend an die Dampfkammereinrichtung und somit an den Kühlkörper übertragen werden. Somit kann eine verbesserte Kühlung des Leistungsmoduls realisiert werden.

Eine weitere vorteilhafte Ausgestaltungsform sieht vor, dass der Kühlkörper aus Aluminium ausgebildet ist. Insbesondere Aluminium ist sehr kostengünstig und leicht und weist dennoch einen entsprechenden Wärmeleitkoeffizienten auf, um eine zuverlässige Entwärmung des Leistungsmoduls realisieren zu können.

Gemäß einer weiteren vorteilhaften Ausgestaltungsform ist das Leistungsmodul an der Kontaktstelle mit dem Kühlkörper verlötet. Somit kann eine zuverlässige Verbindung zwischen dem Leistungsmodul und dem Kühlkörper realisiert werden. Des Weiteren kann über die Lötstelle ein zuverlässiger Wärmeübertrag mit realisiert werden. Ferner kann über die Lötstelle zuverlässig eine Abdichtung zwischen dem Leistungsmodul und dem Kühlkörper realisiert werden, sodass die Dampfkammereinrichtung zuverlässig betrieben werden kann.

Ebenfalls vorteilhaft ist, wenn eine Sinterverbindung zwischen dem Leistungsmodul und dem Kühlkörper an der Kontaktstelle ausgebildet ist. Somit kann eine zuverlässige Verbindung zwischen dem Leistungsmodul und dem Kühlkörper realisiert werden. Des Weiteren kann über die Sinterverbindung ein zuverlässiger Wärmeübertrag mit realisiert werden. Ferner kann über die Sinterverbindung zuverlässig eine Abdichtung zwischen dem Leistungsmodul und dem Kühlkörper realisiert werden, sodass die Dampfkammereinrichtung zuverlässig betrieben werden kann.

In einer weiteren vorteilhaften Ausgestaltungsform ist vorgesehen, dass der Kühlkörper an einem Rand der weiteren Seite eine Erhebung aufweist, wobei das Leistungsmodul an der Erhebung anordenbar ist. Insbesondere weist der Kühlkörper einen Aufnahmebereich auf, welcher dazu ausgebildet ist, das Leistungsmodul im Wesentlichen bereichsweise aufzunehmen. Hierzu ist am Rand dieses Aufnahmebereichs wiederum die Erhebung vorgesehen. Dadurch kann verhindert werden, dass das Leistungsmodul ganz in den Aufnahmebereich aufgenommen wird. Somit kann ein Abstand zwischen dem Kühlkörper und dem Leistungsmodul geschaffen werden, welcher insbesondere dann wiederum den Aufnahmebereich für das Kühlfluid der Dampfkammereinrichtung bildet. Somit kann eine verbesserte Kühlung des Leistungsmoduls realisiert werden.

In einer weiteren vorteilhaften Ausgestaltungsform ist vorgesehen, dass die Anordnung zumindest ein Verbindungselement aufweist, welche die Seite des Leistungsmoduls mit der Erhebung verbindet. Insbesondere, da das Leistungsmodul flächenmäßig deutlich kleiner ausgebildet ist als der Kühlkörper kann über das Verbindungselement eine Verbindung geschaffen werden, welche gleichzeitig als Teil der Dampfkammereinrichtung genutzt werden kann und weiterhin zuverlässig eine Verbindung und somit Abdichtung zwischen dem Kühlkörper und dem Leistungsmodul bildet.

Ferner kann vorgesehen sein, dass das zumindest eine Verbindungselement an einer der Dampfkammereinrichtung zugewandten Seite nochmals weitere Kühlrippen aufweist. Insbesondere ragen die Kühlrippen dann wiederum in die Dampfkammereinrichtung hinein. Somit kann eine Flächenvergrößerung stattfinden und ein Wärmeübertrag auch über das Verbindungselement in die Dampfkammereinrichtung realisiert werden. Somit kann eine verbesserte Entwärmung des Leistungsmoduls durchgeführt werden.

Ein weiterer Aspekt der Erfindung betrifft eine elektronische Recheneinrichtung mit einer Anordnung nach dem vorhergehenden Aspekt. Unter elektronischer Recheneinrichtung kann insbesondere eine Steuereinrichtung und/oder eine Leistungselektronik angesehen werden.

Vorteilhafte Ausgestaltungsformen der Anordnung sind als vorteilhafte Ausgestaltungsformen der elektronischen Recheneinrichtung anzusehen.

Unter einer Recheneinheit kann insbesondere ein Datenverarbeitungsgerät verstanden werden, das einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere Einchipsysteme, SoC (englisch: "system on a chip"). Die Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere Digitalsignalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCRAM (englisch: "phase-change random access memory"), ausgestaltet sein.

Unabhängig vom grammatikalischen Geschlecht eines bestimmten Begriffes sind Personen mit männlicher, weiblicher oder anderer Geschlechteridentität mit umfasst.

Weitere Merkmale und Merkmalskombinationen der Erfindung ergeben sich aus den Figuren und deren Beschreibung sowie aus den Ansprüchen. Insbesondere müssen weitere Ausführungsformen der Erfindung nicht unbedingt alle Merkmale eines der Ansprüche enthalten. Weitere Ausführungsformen der Erfindungen können Merkmale oder Merkmalskombinationen aufweisen, die nicht in den Ansprüchen genannt sind.

Dabei zeigen:
FIG 1 eine schematische Schnittansicht einer Ausführungsform einer Anordnung in einem nicht zusammengebauten Zustand; und
FIG 2 eine weitere schematische Schnittansicht einer Ausführungsform der Anordnung in einem zusammengebauten Zustand.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

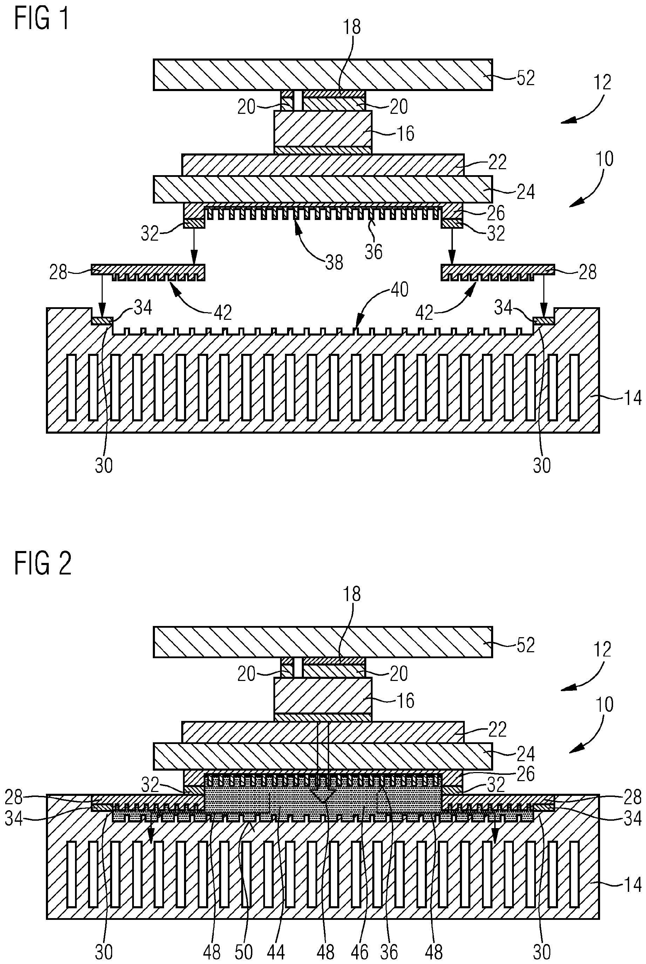

FIG 1 zeigt in einer schematischen Schnittansicht eine Ausführungsform einer Anordnung 10 für eine nicht dargestellte elektronische Recheneinrichtung. Dabei ist insbesondere die Anordnung 10 in einem nicht zusammengebauten Zustand gezeigt.

Die Anordnung 10 weist im vorliegenden Ausführungsbeispiel insbesondere ein Leistungsmodul 12 sowie einen Kühlkörper 14 auf. Das Leistungsmodul 12 ist im vorliegenden Ausführungsbeispiel insbesondere durch eine Leiterplatte 52 sowie einem Leistungschip 16 ausgebildet. Der Leistungschip 16 ist über eine entsprechende Kontaktierung 18 mit der Leiterplatte 52 gekoppelt. Hierzu sind entsprechende Bauelemente 20, beispielsweise Gate und Source, des Leistungschips 16 insbesondere mit der Leiterplatte 52 gekoppelt.

Der Leistungschip 16 ist wiederum mit einer ersten metallischen Komponente 22 gekoppelt. Die erste metallische Komponente 22 dient insbesondere zur Aufnahme der Wärme des Leistungschips 16.

Die erste metallische Komponente 22 ist wiederum mit einer Keramikschicht 24 ausgebildet. Die Keramikschicht 24 bildet insbesondere eine elektrische Isolation für den Leistungschip 16.

Ferner ist die Keramikschicht 24 wiederum mit einer zweiten metallischen Komponente 26 gekoppelt. Ferner sind Verbindungselemente 28 gezeigt.

Des Weiteren ist gezeigt, dass der Kühlkörper 14 mindestens eine Erhebung 30 aufweist. Die Erhebung 30 ist wiederum dazu ausgebildet in einem ersten Ausführungsbeispiel mit der zweiten metallischen Komponente 26 zu korrespondieren beziehungsweise im vorliegenden Ausführungsbeispiel mit den Verbindungselementen 28 zu korrespondieren.

Ferner ist im vorliegenden Ausführungsbeispiel gezeigt, dass beispielsweise die zweite metallische Komponente 26 über ein erstes Dichtelement 32 mit den Verbindungselementen 28 gekoppelt werden kann. Dies kann beispielsweise in Form einer Lötverbindung oder einer Sinterverbindung realisiert werden.

Ferner ist im vorliegenden Ausführungsbeispiel gezeigt, dass über eine weitere Dichtkomponente 34 die Verbindungselemente 28 mit dem Kühlkörper 14 verbunden werden können. Dies dient insbesondere ebenfalls als Abdichtung, wobei diese ebenfalls als Lötverbindung beziehungsweise als Sinterverbindung bereitgestellt werden können.

Die erste metallische Komponente 22, die zweite metallische Komponente 26 sowie Verbindungselemente 28 können dabei insbesondere aus Kupfer ausgebildet sein. Der Kühlkörper 14 ist bevorzugt aus Aluminium ausgebildet.

Ferner zeigt die FIG. 1, dass zumindest eine Seite 36, insbesondere an der zweiten metallischen Komponente 26, Kühlrippen 38 aufweist. Des Weiteren kann auch der Kühlkörper 14 weitere Kühlrippen 40 aufweisen. Ferner ist im vorliegenden Ausführungsbeispiel gezeigt, dass auch die Verbindungselemente 28 nochmals weitere Kühlrippen 42 aufweisen können.

FIG. 2 zeigt wiederum die Anordnung aus der FIG. 1 im zusammengebauten Zustand. Insbesondere zeigt die FIG. 2 dass zwischen dem Leistungsmodul 12 und dem Kühlkörper 14 nun eine Dampfkammereinrichtung 44 ausgebildet wird. Insbesondere wird in einem Innenraum zwischen der Leistungsmodul 12 und dem Kühlkörper 14 ein entsprechendes Fluid 46 bereitgestellt, welches wiederum für den Betrieb der Dampfkammereinrichtung 44 ausgebildet ist. Über entsprechende Pfeile 48 ist in der FIG. 2 insbesondere ein Wärmeübertrag vom Leistungsmodul 12 zum Kühlkörper 14 gezeigt.

Insbesondere ist somit vorgesehen, dass zumindest die Seite 36 der Dampfkammereinrichtung 44 durch das Leistungsmodul 12 begrenzt ist und eine weitere Seite 50 der Dampfkammereinrichtung 44 durch den Kühlkörper 14 begrenzt ist.

Des Weiteren zeigt die FIG. 2, dass die Seite 36 zum Leistungsmodul 14 eine geringere Fläche aufweist als die weitere Seite 50 zum Kühlkörper 14.

Insbesondere zeigen somit die Figuren 1 und 2 eine Eliminierung der Festkörpergrenzflächen durch die Gestaltung einer gemeinsamen Vapour Chamber, insbesondere der Dampfkammereinrichtung 44, zwischen dem Leistungsmodul 12 und dem Kühlkörper 14. Dies ermöglicht eine Verbesserung der lateralen Wärmespreizung durch die Ausdehnung der Kontaktfläche innerhalb des Kühlkörpers 14. Des Weiteren kann eine Funktionsintegration der unteren Metallisierungsschicht des Leistungsmoduls 12 durch die Gestaltung als oberer Halbschale, insbesondere als Evaporationsseite, mit entsprechender Topografie, beispielsweise mit den Kühlrippen 38, realisiert werden. Ferner kann auch die fertigungsgerechte Gestaltung durch die Anwendung auf eine den Kühlkörper 14 gefügten Deckplatte durchgeführt werden.

### Bezugszeichenliste

- 10: Anordnung
- 12: Leistungsmodul
- 14: Kühlkörper
- 16: Leistungschip
- 18: Verbindung
- 20: Komponente
- 22: erste metallische Komponente
- 24: Keramikschicht
- 26: zweite metallische Komponente
- 28: Verbindungselement
- 30: Erhebung
- 32: Dichtelement
- 34: weiteres Dichtelement
- 36: Seite
- 38: Kühlrippen
- 40: weitere Kühlrippen
- 42: weitere Kühlrippen
- 44: Dampfkammereinrichtung
- 46: Fluid
- 48: Wärmeübertrag
- 50: weitere Seite
- 52: Leiterplatte

## Patentansprüche

1. Anordnung (10) für eine elektronische Recheneinrichtung mit zumindest einem Leistungsmodul (12) und einem Kühlkörper (14) zum Kühlen des Leistungsmoduls (12),
**dadurch gekennzeichnet, dass**
zwischen dem Leistungsmodul (12) und dem Kühlkörper (14) eine Dampfkammereinrichtung (44) ausgebildet ist, wobei zumindest eine Seite (36) der Dampfkammereinrichtung (44) durch das Leistungsmodul (12) begrenzt ist und zumindest eine weitere Seite (50) der Dampfkammereinrichtung (44) durch den Kühlkörper (14) begrenzt ist.

2. Anordnung (10) nach Anspruch 1, **dadurch gekennzeichnet, dass**
an der Seite (36) des Leistungsmoduls (12) Kühlrippen (38) ausgebildet sind.

3. Anordnung (10) nach Anspruch 1 oder 2, **dadurch gekennzeichnet, dass**
an der weiteren Seite (50) des Kühlkörpers (14) weitere Kühlrippen (40) ausgebildet sind.

4. Anordnung (10) nach einem der vorhergehenden Ansprüche, **dadurch gekennzeichnet, dass**
die Seite (36) zum Leistungsmodul (12) eine geringere Fläche aufweist, als die weitere Seite (50) zum Kühlkörper (14).

5. Anordnung (10) nach einem der vorhergehenden Ansprüche, **dadurch gekennzeichnet, dass**
an zumindest einer Kontaktstelle des Leistungsmoduls (12) mit dem Kühlkörper (14) ein Dichtelement (32) angeordnet ist.

6. Anordnung (10) ach einem der vorhergehenden Ansprüche, **dadurch gekennzeichnet, dass**
das Leistungsmodul (12) zumindest eine metallische Komponente (22, 26) Begrenzung zur Dampfkammereinrichtung (44) ausbildet.

7. Anordnung (10) nach Anspruch 6, **dadurch gekennzeichnet, dass**
die metallische Komponente (22, 26) aus Kupfer ausgebildet ist.

8. Anordnung (10) nach einem der Ansprüche 6 oder 7, **dadurch gekennzeichnet, dass**
die metallische Komponente (22, 26) gegenüber einem Leistungschip (16) des Leistungsmoduls (12) elektrisch isoliert ist.

9. Anordnung (10) nach Anspruch 8, **dadurch gekennzeichnet, dass**
die elektrische Isolation als eine Keramikschicht (24) ausgebildet ist.

10. Anordnung (10) nach einem der vorhergehenden Ansprüche, **dadurch gekennzeichnet, dass**
der Kühlkörper (14) aus Aluminium ausgebildet ist.

11. Anordnung (10) nach einem der vorhergehenden Ansprüche, **dadurch gekennzeichnet, dass**
das Leistungsmodul (12) an einer Kontaktstelle mit dem Kühlkörper (14) verlötet ist.

12. Anordnung (10) nach einem der Ansprüche 1 bis 10, **dadurch gekennzeichnet, dass**
eine Sinterverbindung zwischen dem Leistungsmodul (12) und dem Kühlkörper (14) an einer Kontaktstelle ausgebildet ist.

13. Anordnung (10) nach einem der vorhergehenden Ansprüche, **dadurch gekennzeichnet, dass**
der Kühlkörper (14) an einem Rand der weiteren Seite eine Erhebung (30) aufweist, wobei das Leistungsmodul (12) an der Erhebung (30) anordenbar ist.

14. Anordnung (10) nach Anspruch 13, **dadurch gekennzeichnet, dass**
die Anordnung (10) zumindest ein Verbindungselement (28) aufweist, welche die Seite (36) zum Leistungsmodul (12) mit der Erhebung (30) verbindet.

15. Anordnung (10) nach Anspruch 14, **dadurch gekennzeichnet, dass**
das zumindest eine Verbindungselement (28) an einer der Dampfkammereinrichtung (44) zugewandten Seite nochmals weitere Kühlrippen (42) aufweist.
